# EUROPEAN PATENT APPLICATION

(11) **EP 1 914 836 A1**
(43) Date of publication of application: **23.04.2008**
(21) Application number: 05795772.2
(22) Date of filing: 19.10.2005
(51) Int. Cl.: H01Q 9/22, G01R 29/10

(54) **REFERENCE OSCILLATOR**

(30) Priority: 08.08.2005 JP 2005229896
(71) Applicant: MURATA MANUFACTURING CO., LTD., Nagaokakyo-shi, Kyoto 617-8555 (JP)
(72) Inventor: KITADA, Hiroshi, Murata Manufacturing Co., Ltd., Nagaokakyo-shi Kyoto 6178555 (JP); YAMAMOTO, Yukio, Murata Manufacturing Co, . Ltd., Nagaokakyo-shi Kyoto 6178555 (JP); YASUOKA, Yoshihisa, Murata Manufacturing Co., Ltd., Nagaokakyo-shi Kyoto 6178555 (JP); KOMATSU, Hiroshi, Murata Manufacturing Co, . Ltd., Nagaokakyo-shi Kyoto 6178555 (JP)
(74) Representative: Zimmermann, Tankred Klaus
(86) International application number: PCT/JP2005/019191
(87) International publication number: WO 2007/017959

(57) **Abstract**

It is difficult to check the suitability of a radio anechoic room as a measuring environment, even when countermeasures for preventing reflection of electromagnetic waves and blocking electromagnetic waves are taken against the radio anechoic room and incidental equipment disposed therein, for example. Depending on the circumstances, measurement reliability is decreased when the measurement is taken without recognizing that these countermeasures are insufficient. Therefore, there is a demand for a device that can easily and quickly check whether a measuring environment, such as a radio anechoic room, or a measuring system is suitable for measurement.

A reference oscillator assembly 10 of the present invention includes a radiating section 13 formed by removing a part of an outer conductor 12 from a linear coaxial feedline 11, the removed part having a predetermined size and extending from an upper end of the coaxial feedline 11 toward a lower end thereof, an oscillator 14 electrically connected to the lower end of the coaxial feedline 11 so as to supply high-frequency power, and magnetic members 15 and 15 respectively provided at upper and lower ends of a remaining part of the outer conductor 12. of the coaxial feedline 11.

## Description

### Technical Field

The present invention relates to a reference oscillator assembly, and more specifically, to a reference oscillator assembly used to check the suitability of a measuring environment, such as a radio anechoic room or a laboratory, or a measuring system.

### Background Art

A radio anechoic room is formed as a nonreflective space which is surrounded by a wave absorber so as to block electromagnetic waves entering from the outside and to absorb electromagnetic waves radiated from an electromagnetic wave source provided therein in order to prevent reflection of the electromagnetic waves. In the radio anechoic room, a measuring antenna is disposed opposite to an object antenna or an electronic device or the like serving as an object to be measured, and the directivity of the object antenna is measured, or the influence of electromagnetic waves associated with the electronic device or the like is measured.

Various measurements are taken of the object, such as the object antenna or the electronic apparatus, in a predetermined manner while the object and its incidental device are placed in the radio anechoic room. An incidental device is sometimes a reflection source for reflecting electromagnetic waves or a radiation source for radiating electromagnetic waves. Accordingly, measurement of directivity of the antenna and electromagnetic waves associated with the electronic device are prevented from being hindered by the reflection source and the radiation source, by taking countermeasures against the reflection source and the radiation source so as to prevent reflection of electromagnetic waves and to block unnecessary electromagnetic waves.

### Disclosure of Invention

### Problems to be Solved by the Invention

Conventionally, however, it is difficult to check the suitability of a radio anechoic room as a measuring environment, for example, even when countermeasures for preventing reflection of electromagnetic waves and blocking electromagnetic waves are taken against the radio anechoic room and the incidental equipment disposed therein. Depending on the circumstances, measurement reliability is decreased when measurements are performed without recognizing that these countermeasures are insufficient. Therefore, there is a demand for a device that can easily and quickly check whether a measuring environment, such as a radio anechoic room, or a measuring system is suitable for measurement.

The present invention has been made to solve the above-described problems, and an object of the invention is to provide a reference oscillator assembly as a device that can easily and quickly check the suitability of a measuring environment, such as a radio anechoic room or a laboratory, or a measuring system.

### Means for Solving the Problems

As results of various studies on methods for checking the suitability of the measuring environment in a radio anechoic room, the present inventors have focused their attention on a nondirectional sleeve antenna as a simple and easy means for checking the suitability of the measuring environment. As an example of a sleeve antenna, a technique proposed in Patent Document 1 is known. This sleeve antenna includes a radiating section of a predetermined length formed by removing a part of an outer conductor from a leading end of a coaxial feedline, a sleeve of a predetermined length that covers a part of the coaxial feedline extending from the base end of the radiating section away from the radiating section, and a magnetic member covering at least the base end of the sleeve.

Patent Document 1: Japanese Unexamined Patent Application Publication No. 2004-336303

However, it was found that a radiation gain pattern having non-directivity was lost shape by the following problems in the sleeve antenna disclosed in Patent Document 1, and the sleeve antenna could not be used as a means for checking the suitability of the measuring environment:
(1) Since a leakage current flows to a part of the outer conductor of the coaxial feedline that constitutes the sleeve, it disturbs the directivity of the antenna.
(2) When the coaxial feedline is not linear, electromagnetic waves leaking from the feedline are radiated not only in an orthogonal polarization mode, but also in other modes, and therefore, the directivity of the antenna is disturbed.

It was also found that the following problems were caused when an oscillator for supplying high-frequency power was connected to the sleeve antenna:
(1) Standing waves are produced between a joint surface between the oscillator and the coaxial feedline, and the base end of the radiating section, and leaking magnetic waves due to the standing waves disturb the directivity of the antenna.
(2) When the oscillator is not electromagnetically shielded, the directivity of the antenna is disturbed by electromagnetic waves leaking from the oscillator.
(3) When the oscillator is driven by power supplied from a power supply cable, the directivity of the antenna is disturbed by electromagnetic waves leaking from the power supply cable.

The present invention has been made on the basis of the above findings. A reference oscillator assembly claimedin claim 1 of the invention includes a radiating section formed by removing a part of an outer conductor from a linear coaxial feedline, the removed part having a predetermined size and extending from one end of the coaxial feedline toward the other end thereof; an oscillator connected to the other end of the coaxial feedline so as to supply high-frequency power; and a magnetic member provided at each of one end and the other end of a remaining part of the outer conductor of the coaxial feedline.

In a reference oscillator assembly claimed in claim 2, according to the invention claimed in claim 1, the coaxial feedline has a strong structure and stands vertically.

In a reference oscillator assembly claimed in claim 3, according to the invention claimed in claim 1 or 2, the coaxial feedline, the oscillator, and the magnetic member are supported by a support that is formed of a dielectric having a low dielectric constant.

In a reference oscillator assembly claimed in claim 4, according to the invention claimed in any one of claims 1 to 3, the magnetic member is formed by a cylinder that is in tight contact with the outer conductor of the coaxial feedline.

In a reference oscillator assembly claimed in claim 5, according to the invention claimed in any one of claims 1 to 4, the magnetic member is formed of ferrite.

In a reference oscillator assembly claimed in claim 6, according to the invention claimed in any one of claims 1 to 5, the oscillator is electromagnetically shielded.

In a reference oscillator assembly claimed in claim 7, according to the invention claimed in any one of claims 1 to 6, a driving power source is provided in the oscillator.

In a reference oscillator assembly claimed in claim 8, according to the invention claimed in any one of claims 3 to 7, the support is formed of styrene foam.

### Advantages of the Invention

According to the inventions claimed in claims 1 to 8, it is possible to provide a reference oscillator assembly as a device that can easily and quickly check the suitability of a measuring environment, such as a radio anechoic room or a laboratory, or a measuring system.

### Brief Description of the Drawings

[Fig. 1] Fig. 1 is a perspective view of a reference oscillator assembly according to an embodiment of the present invention.
[Fig. 2] Fig. 2 is a perspective view showing a state in which the reference oscillator assembly shown in Fig. 1 is supported by a support.
[Fig. 3] Fig. 3 is a view showing a radiation gain pattern on the Ii-plane of electromagnetic waves radiated from a radiating section of the reference oscillator assembly shown in Fig. 1.

### Reference Numerals

- 10: reference oscillator assembly
- 11: coaxial feedline
- 12: outer conductor
- 13: radiating section
- 14: oscillator
- 15: magnetic member
- 16: support

### Best Mode for Carrying Out the Invention

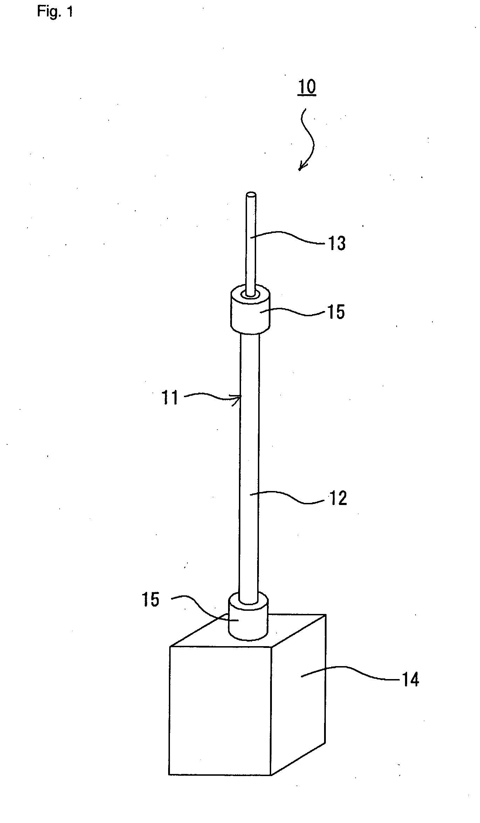

The present invention will be described below with reference to an embodiment shown in Figs. 1 to 3.

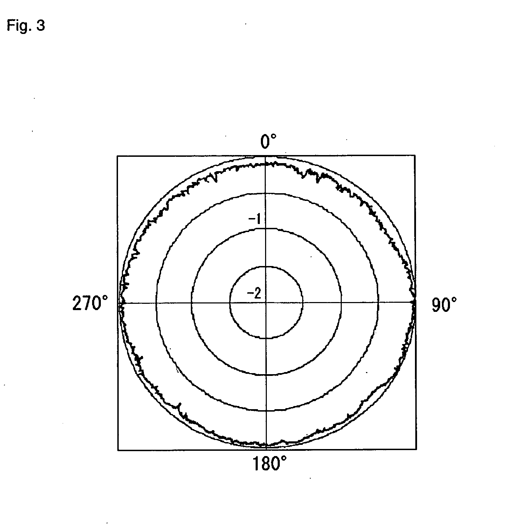

For example, as shown in Fig. 1, a reference oscillator assembly 10 according to this embodiment includes a radiating section 13 formed of a core wire by removing a part of an outer conductor 12 having a predetermined size from a linear coaxial feedline 11 from one end (upper end) toward the other end (lower end), an oscillator 14 electrically connected to the lower end of the coaxial feedline 11 so as to feed high-frequency power, and magnetic members 15 respectively provided at the upper and lower ends of the remaining part of the outer conductor 12 of the coaxial feedline 11. Nondirectional electromagnetic waves are radiated from the radiating section 13. The reference oscillator assembly 10 is constructed such that the radiating section 13 is vertically positioned above an upper surface of the oscillator 14. Since the radiating section 13 is vertically positioned above the upper surface of the oscillator 14, electromagnetic waves from the radiating section 13 form a nondirectional radiation gain pattern on the H-plane (see Fig. 3) .

The coaxial feedline 11 includes a cylindrical and strong outer conductor 12 that is resistant to deformation, a core wire disposed along the axis of the outer conductor 12, and a dielectric interposed between the outer conductor 12 and the core wire. The radiating section 13 is formed of a part of the core wire that is exposed by removing an upper part of the outer conductor 12. The core wire and the outer conductor 12 of the coaxial feedline 11 are connected to a feeding point of the oscillator 14. Since the coaxial feedline 11 is strong and linear, electromagnetic waves leaking from the coaxial feedline 11 are radiated only in an orthogonal polarization mode, and do not disturb the directivity of the radiating section 13.

For example, the radiating section 13 is formed of a core wire obtained by removing a part of the outer conductor 12 having a predetermined length from the coaxial feedline 11 from the upper end toward the lower end. While the length of the radiating section 13 is not particularly limited as long as it radiates high-frequency power, for example, it is preferable that the length be set to be equal to one-fourth, one-half, or one-eighth of the wavelength of the high-frequency power. It is preferable that the length of the remaining part of the outer conductor 12 other than the radiating section 13 be set, for example, to be equal to the length of the radiating section 13. When the length of the radiating section 13 is equal to one-fourth of the wavelength of the high-frequency power, the length of the outer conductor 12 is preferably set to be equal to one-fourth of the wavelength of the high-frequency power.

The oscillator 14 incorporates, for example, a battery (not shown) as a driving power source, and is connected so as to produce a predetermined high-frequency power by using the battery as the driving power source and to supply the high-frequency power to the coaxial feedline 11. Since the battery is provided in the oscillator 14, a power supply line, such as a cable, is unnecessary outside the oscillator 14. A housing of the oscillator 14 is made of metal and has an electromagnetic shielded structure. The metal housing is covered with a known electromagnetic wave absorber so as not to reflect electromagnetic waves.

For example, as shown in Fig. 1, the magnetic member 15 provided at each of the upper and lower ends of the outer conductor 12 is cylindrical, is formed of a magnetic material, and is in tight contact with the outer conductor 12. For example, ferrite is preferably used as the magnetic material. In this embodiment, for example, a ferrite bead core is used as the magnetic member 15.

A high-frequency current flows through the outer conductor 12 by the supply of the high-frequency power, and standing waves are produced between a joint surface between the coaxial feedline 11 and the oscillator 14, and a base end of the radiating section 13 (disposed at an upper end face of the upper magnetic member 15). Since the current and standing waves flowing through the outer conductor 12 are restricted by the upper and lower magnetic members 15, leakage of electromagnetic waves due to the standing waves in the outer conductor 12 can be suppressed. Consequently, the reference oscillator assembly 10 minimizes the radiation of electromagnetic waves from the portions other than the radiating section 13, radiates electromagnetic waves only from the radiating section 13, and does not disturb the non-directivity on the H-plane.

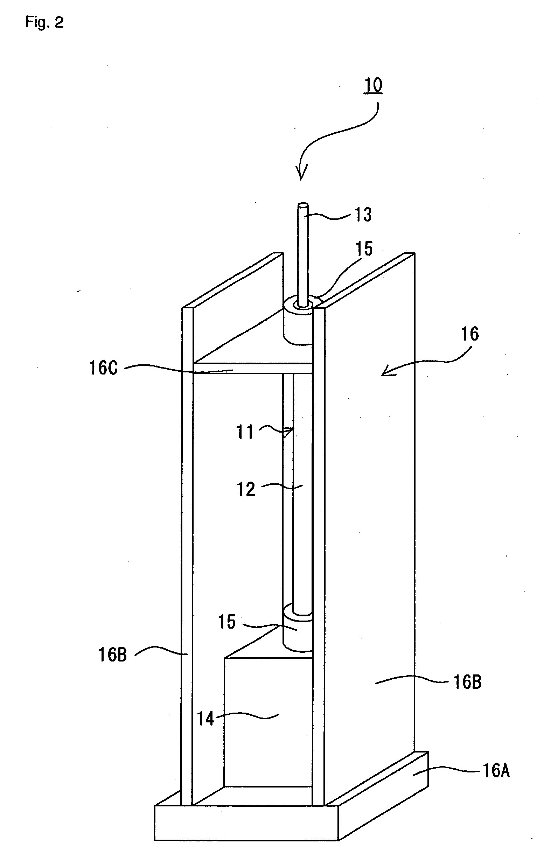

The reference oscillator assembly 10 shown in Fig. 1 is unstable because it has a self-supporting structure in which the coaxial feedline 11 vertically stands on the upper surface of the oscillator 14. Accordingly, the reference oscillator assembly 10 of this embodiment includes a support 16, for example, as shown in Fig. 2.

As shown in Fig. 2, the support 16 includes a base 16A on which the oscillator 14 is mounted, a pair of support plates 16B and 16B standing such as to sandwich the oscillator 14 from the right and left sides, and a bearing plate 16C laid between upper portions of the support plates 16B and 16B such as to bear the magnetic member 15 disposed at the upper end of the outer conductor 12. The support 16 is integrally formed of a dielectric material such as styrene foam. Since the support 16 is formed of a dielectric material such as styrene foam, it does not reflect electromagnetic waves, and does not disturb a radiation gain pattern of electromagnetic waves radiated from the reference oscillator assembly 10.

In the reference oscillator assembly 10 of this embodiment, electromagnetic waves are radiated from the radiating section 13 by supplying high-frequency power from the oscillator 14 to the coaxial feedline 11. Since the coaxial feedline 11 vertically stands on the upper surface of the oscillator 14, the radiation gain pattern on the H-plane has substantially uniform gain values with variation values within ±0.2 dB ° at angles between 0° and 360° inclusive, for example, as shown in Fig. 3. When a reflection source for reflecting electromagnetic waves or a radiation source for radiating unwanted electromagnetic waves is provided near the radiating section 13, because electromagnetic waves from the radiating section 13 are reflected by the reflection source, or because of the influence of unwanted electromagnetic waves, the substantially circular radiation gain pattern having the substantially uniform gain values is disturbed and lost shape. In this embodiment, the suitability of an electromagnetic-wave environment, that is, the measuring environment of the radio anechoic room is checked by utilizing this property of the radiation gain pattern of the radiating section 13. Since the suitability of the measuring environment in the radio anechoic room is checked by utilizing the radiation gain pattern on the H-plane, the uniformity of the radiation gain pattern is more important than the volume of the gain, and the gain may be small.

A description will now be given of how to check the suitability of the measuring environment of the radio anechoic room with the reference oscillator assembly 10 of this embodiment.

First, the reference oscillator assembly 10 of this embodiment is placed on a turntable provided in the radio anechoic room. When the oscillator 14 is then switched on and driven, high-frequency power is supplied from the oscillator 14 to the coaxial feedline 11, and electromagnetic waves are radiated from the radiating section 13. The radiation gain pattern on the H-plane is substantially circular, and has the substantially uniform gain values with the variation values within ±0.2 dB ° at angles between 0° and 360° inclusive. If a reflection source for reflecting electromagnetic waves is provided besides the reference oscillator assembly 10 in the radio anechoic room, electromagnetic waves radiated from the reference oscillator assembly 10 are reflected, and disturb the radiation gain pattern of the radiating section 13. Further, if another radiation source for radiating electromagnetic waves is provided, the radiation gain pattern is disrupted by the electromagnetic waves. Therefore, it is possible to easily and quickly check, on the basis of the form of the radiation gain pattern of the reference oscillator assembly 10, whether an unnecessary source for reflecting or radiating electromagnetic waves is provided in the radio anechoic room, and whether the radio anechoic room is suitable as a measuring environment for an object to be measured.

As described above, according to the embodiment, the reference oscillator assembly 10 includes the radiating section 13 formed of a core wire by removing a part of the outer conductor 12 having a predetermined size from the linear coaxial feedline 11 from the upper end toward the lower end of the linear coaxial feedline 11, the oscillator 14 electrically connected to the lower end of the coaxial feedline 11 so as to supply high-frequency power, and the magnetic members 15 and 15 respectively provided at the upper and lower ends of the remaining part of the outer conductor 12 of the coaxial feedline 11. Since the coaxial feedline 11 has a strong structure and stands vertically, when the suitability of the measuring environment is checked with the reference oscillator assembly 10 placed in the radio anechoic room, the radiation gain pattern on the H-plane of electromagnetic waves radiated from the radiating section 13 has the substantially uniform gain values at angles between 0° and 360° inclusive. By simply observing the radiation gain pattern, it can be easily and quickly checked whether an unnecessary source for reflecting or radiating electromagnetic waves is provided in the radio anechoic room, that is, whether the radio anechoic room is suitable as the measuring environment. Further, since electromagnetic waves leaking from the coaxial feedline 11 are radiated only in an orthogonal polarization mode, they do not disturb the directivity of the radiating section 13.

According to the embodiment, the coaxial feedline 11, the oscillator 14, and the magnetic member 15 are supported by the support 16 formed of styrene foam, and the magnetic members 15 are formed as ferrite bead cores such as to be in tight contact with the coaxial feedline 11. Therefore, the position of the reference oscillator assembly 10 is stabilized, the upper and lower magnetic members 15 and 15 are reliably fixed, and the current flowing through the outer conductor 12 is reliably suppressed. Moreover, leaking electromagnetic waves due to standing waves between the upper and lower magnetic members 15 and, 15 can be reliably suppressed, and a stable radiation gain pattern can be obtained. In addition, since the oscillator 14 is electromagnetically shielded and incorporates the battery, unnecessary electromagnetic waves are not radiated from the oscillator 14. Since a power supply cable or the like is not provided outside the oscillator 14, unnecessary electromagnetic waves are not radiated outside the oscillator 14.

The present invention is not limited to the above-described embodiment, and components in the present invention may be appropriately changed in design, as required.

### Industrial Applicability

The present invention is suitably applied to a device for checking the suitability of a measuring environment, such as a radio anechoic room or a laboratory, or a measuring system.

## Claims

1. A reference oscillator assembly comprising:
a radiating section formed by removing a part of an outer conductor from a linear coaxial feedline, the removed part having a predetermined size and extending from one end of the coaxial feedline toward the other end thereof;
an oscillator connected to the other end of the coaxial feedline so as to supply high-frequency power; and
a magnetic member provided at each of one end and the other end of a remaining part of the outer conductor of the coaxial feedline.

2. The reference oscillator assembly according to claim 1, wherein the coaxial feedline has a strong structure and stands vertically.

3. The reference oscillator assembly according to claim 1 or 2, wherein the coaxial feedline, the oscillator, and the magnetic member are supported by a support that is formed of a dielectric having a low dielectric constant.

4. The reference oscillator assembly according to any one of claims 1 to 3, wherein the magnetic member is formed by a cylinder that is in tight contact with the outer conductor of the coaxial feedline.

5. The reference oscillator assembly according to any one of claims 1 to 4, wherein the magnetic member is formed of ferrite.

6. The reference oscillator assembly according to any one of claims 1 to 5, wherein the oscillator is electromagnetically shielded.

7. The reference oscillator assembly according to any one of claims 1 to 6, wherein a driving power source is provided in the oscillator.

8. The reference oscillator assembly according to any one of claims 3 to 7, wherein the support is formed of styrene foam.
